# EUROPEAN PATENT APPLICATION

(11) **EP 2 187 294 A1**
(43) Date of publication of application: **19.05.2010**
(21) Application number: 09013954.4
(22) Date of filing: 06.11.2009
(51) Int. Cl.: G06F 3/044, G06F 3/045

(54) **Capacitive coupling type touch panel**

(30) Priority: 06.11.2008 JP 2008285548; 06.03.2009 JP 2009053043
(71) Applicant: Hitachi Displays, Ltd., Mobara-shi Chiba (JP)
(72) Inventor: Tanaka, Jun, Tokyo 100-8220 (JP); Sekiguchi, Shinji, Tokyo 100-8220 (JP); Mamba, Norio, Tokyo 100-8220 (JP); Hamamoto, Tatsuo, Tokyo 100-8220 (JP)
(74) Representative: Beetz & Partner

(57) **Abstract**

A capacitive touching type touch panel detects a position by detecting a change of a capacitance between a finger tip and a position detection electrode. Thus, when touched by a perfect insulator, static electricity on the surface thereof is not changed enough so that it is unable to detect the position.

In order to solve this problem, the invention proposes a capacitive coupling type touch panel including an XY-coordinate electrode configured to detect an XY-position coordinate. The XY-coordinate electrode is provided on a transparent substrate and detects a position inputted by capacitive coupling. The capacitive coupling type touch panel also includes an electrode provided at a position so as to be isolated from and opposed to the XY-coordinate electrode.

## Description

### BACKGROUND OF THE INVENTION

### 1. Field of the Invention

The present invention relates to a capacitive coupling type touch panel and a display device on which the touch panel is mounted. In particular, the present invention relates to a capacitive coupling type touch panel adapted for a resin pen input.

### 2. Description of the Related Art

A touch panel is an appliance that has, when combined with a display device, a function of detecting a position when a touch panel screen corresponding to a display area of the display device is touched (pressed) with a finger or a pen and inputting a position coordinate and the like to the display device.

Due to the operation principle, various types are available for the touch panel, such as a resistance film type, a capacitive couplingtype, an infrared type, an acoustic pulse type, an ultrasonic type, and an electromagnetic induction coupling type.

Of those, the resistance film type and capacitive coupling type touch panels are advantageous in terms of a cost. Recently, the resistance film type and capacitive coupling type touch panels are mounted on mobile appliances such as a mobile phone and a microminiaturized personal computer and are combined with display devices to be used as input devices.

The resistance film type touch panel has a configuration in which a counter substrate (polyethylene terephthalate film, etc.) to be a touch surface is attached to a transparent substrate made of glass or the like to be a base via gap spacers placed on the surface of the transparent substrate. Transparent electrodes such as indium tin oxide films are formed in a lattice shape on the opposed surfaces of these substrates.

When the substrate to be the touch surface is not touched, these electrodes do not come into contact with each other between the substrates due to the spacers. When the substrate to be the touch surface is touched, the substrate is warped by a pressure so as to approach the base substrate, whereby the electrodes come into contact with each other between the substrates. At this time, the ratio between voltages divided by the resistances of the transparent electrodes on the respective substrate surfaces is measured to detect a touched position, which becomes a position input signal to the display device. Therefore, it is required that the electrodes on the substrate surfaces come into contact with each other in the resistance film type touch panel. Further, a position is detected by contacting the electrodes on the substrate surfaces, and, thus, an input using a resin pen is also available.

In the capacitive coupling type touch panel, patterned transparent electrodes detecting a touched position are formed on a touch panel screen on a touch panel substrate that corresponds to a display area of a display device. , Also, a wiring for extracting a position detection signal from the transparent electrodes is formed on the periphery of the touch panel screen, and a wiring circuit for outputting the position detection signal to an external detection circuit or the like is provided.

In general, the capacitive coupling type touch panel has an advantage of detecting a touched position at high speed, and grasps a change in a capacitance between the finger tip and the position detection electrode based on the finger touch so as to detect the position. For example, in the case of detecting an XY-position, XY-position detection electrodes are insulated from each other.

When a general capacitive coupling type touch panel is touched with a perfect insulator, static electricity on the surface is unlikely to change, which makes it impossible to detect a position. Therefore, the input with a resin pen or the like cannot be performed, and a touch pen with conductivity is required.

Further, in a display device with a touch sensor in which a touch sensor device and a display device are attached to each other, the substrate of the touch sensor is attached to the substrate of the display device, and, hence, the display device is thick as a whole. In order to solve this problem, a display device into which a touch sensor function is integrated is proposed.

As examples of the resistance film type touch panel, there are known Japanese Patent Application Laid-open No. Hei 05-113843, Japanese Patent Application Laid-open No. Hei 09-185457, Japanese Patent Application Laid-open No. 2004-117646, and Japanese Patent Application Laid-open No. 2005-31805.

As examples of the capacitive coupling type touch panel, there are known Japanese Patent Application Laid-open No. 2008-32756 and Japanese Patent Application Laid-open No. 2008-134522.

As a pen-inputting touch panel input device, Japanese Patent Application Laid-open No. Hei 08-179872 discloses a combination of a capacitive coupling type and an ultrasonic type.

Japanese Patent Application Laid-open No. 2008-216543 discloses an example in which a capacitive coupling type touch sensor function is contained in an organic electroluminescence display device.

### SUMMARY OF THE INVENTION

In order to achieve the above-mentioned object, a capacitive coupling type touch panel of one or more embodiments of the present invention is characterized by the feature of claim 1 and in that a position can be detected when the panel is touched with a resin pen or other insulators.

The capacitive coupling type touch panel of one or more embodiments of the present invention may in particular include an electrode circuit that detects an XY-position coordinate on a transparent substrate and includes a floating electrode at a position so as to be isolated from and be opposed to the XY-position coordinate electrode. When the floating electrode is touched with a pen to allow the floating electrode to approach the XY-position coordinate electrode, capacitive coupling occurs between the floating electrode and the XY-position coordinate electrode so that the position touched with the pen is detected.

At this time, the floating electrode is pressed with a load that occurs when touched with the pen so thatcapacitive coupling occurs between the floating electrode and the XY-position coordinate electrode. The position touched with the pen can be detected by detecting the position where the capacitive coupling occurs. Therefore, even if the floating electrode is touched with a resin pen or other insulators, the capacitance between the floating electrode and the position detection electrode can be changed.

The XY-position coordinate electrode and the floating electrode may be made of transparent electrodes, and an oxide transparent electrode is suitable as a transparent electrode material. An indium tin oxide film, an indium zinc oxide film, or a zinc oxide film can be used for the oxide transparent electrode. These films have a certain high level of conductivity and have a function of transmitting visible light.

In the capacitive coupling type touch panel of one or more embodiments of the present invention, the floating electrode is formed at a position isolated from and opposed to the XY-position coordinate electrode. The floating electrode may be formed so as to be opposed to the XY-position coordinate electrode circuit via an insulating film. Therefore, the floating electrode is pressed due to a load that occurs when touched with a pen, the insulating film is deformed in a thickness direction due to the load, and the floating electrode and the XY-position coordinate electrode approach each other. As a result, capacitive coupling occurs between the floating electrode and the XY-position coordinate electrode, which enables a position touched with the pen to be detected.

The insulating film may have a thickness of 10 µm or more and 120 µm or less, whereby the floating electrode is pressed due to a load that occurs when touched with a pen, the insulating film is deformed in a thickness direction due to the load, and the floating electrode and the XY-position coordinate electrode approach each other. Thus, when capacitive coupling occurs between the floating electrode and the XY-position coordinate electrode, a large ratio of the capacitive coupling between a signal and a noise (S/N ratio) can be taken before and after the approach of the floating electrode and the XY-position coordinate electrode, and, hence, a position signal can be detected satisfactorily. On the other hand,when a thickness of the insulating film is less than 10 µm, the capacitive coupling that occurs before the approach of the floating electrode and the XY-position coordinate electrode becomes a signal noise and N is large, resulting in a small S/N ratio, which makes it difficult to detect a position signal. When a thickness of the insulating film is 120 µm or more, the floating electrode and the XY-position coordinate electrode are not allowed to approach each other sufficiently by a small load, and S cannot be increased because of the small amount of the capacitance of capacitive coupling that occurs, resulting in a small S/N ratio, which makes it difficult to detect a position signal.

If the insulating film has light transmittance characteristics of 80% or more and 100% or less, a capacitive coupling type touch panel that is excellent in display performance when combined with a display device can be realized. When the light transmittance is less than 80%, there arises a problem that a display brightness is small.

If the insulating film has refractive index characteristics of 1.30 or more and 1.52 or less, a capacitive coupling type touch panel that is excellent in display performance when combined with a display device can be realized.

Further, due to the presence of a protective layer protecting the floating electrode in an upper layer of the floating electrode, the floating electrode itself may be protected from damages caused by the load from outside, and the performance as the capacitive coupling type touch panel can be held. Further, the protective layer may be formed of a transparent substrate, which can protect the floating electrode itself from damages caused by the load from outside.

In the capacitive coupling type touch panel of the present invention, the floating electrode may be formed so as to be opposed to the XY-position coordinate electrode via a space layer. Therefore, the floating electrode is pressed due to a load occurring when touched with a pen, the space layer is compressed to be deformed in a thickness direction due to the load, and the floating electrode and the XY-position coordinate electrode approach each other, whereby capacitive coupling occurs between the floating electrode and the XY-position coordinate electrode, which enables a position touched with the pen to be detected.

The space layer may have a space thickness of 10 µm or more and 120 µm or less, whereby the floating electrode is pressed due to a load occurring when touched with a pen, the space layer is compressed to be deformed in a thickness direction due to the load, and the floating electrode and the XY-position coordinate electrode approach each other. Thus, when capacitive coupling occurs between the floating electrode and the XY-position coordinate electrode, a large ratio between a signal and a noise (S/N ratio) of the capacitive coupling can be taken before the approach of the floating electrode and the XY-position coordinate electrode and after the approach of the floating electrode and the XY-position coordinate electrode, and, hence, a position signal can be detected satisfactorily.

At this time, the floating electrode may be formed on a second transparent substrate opposed to a transparent substrate on which the XY-position coordinate electrode is formed. By pressing the second transparent substrate, the space present between the floating electrode and the XY-position coordinate electrode is compressed to be deformed in a thickness direction due to the load.

In the capacitive coupling type touch panel of the present invention, the floating electrode may be formed so as to be opposed to the XY-position coordinate electrode via a liquid layer. Therefore, the floating electrode is pressed due to a load that occurs when touched with a pen, and the liquid layer is deformed in a thickness direction due to the load, and the floating electrode and the XY-position coordinate electrode approach each other, whereby capacitive coupling occurs between the floating electrode and the XY-position coordinate electrode, which enables a position touched with the pen to be detected.

The liquid layer may have a thickness of 10 µm or more and 120 µm or less, whereby the floating electrode is pressed due to a load occurring when touched with a pen, the liquid layer is deformed in a thickness direction due to the load, and the floating electrode and the XY-position coordinate electrode approach each other. Thus, when capacitive coupling occurs between the floating electrode and the XY-position coordinate electrode, a large ratio between a signal and a noise of the capacitive coupling can be taken before the approach of the floating electrode and the XY-position coordinate electrode and after the approach of the floating electrode and the XY-position coordinate electrode, and hence, a position signal can be detected satisfactorily.

At this time, the floating electrode may be formed on a second transparent substrate opposed to a transparent substrate on which the XY-position coordinate electrode circuit is formed. By pressing the second transparent substrate, the liquid layer that is present between the floating electrode and the XY-position coordinate electrode is deformed in a thickness direction due to the load.

Because the liquid layer has light transmittance characteristics of 80% or more and 100% or less, a capacitive coupling type touch panel that is excellent in display performance when combined with a display device can be realized. When the light transmittance is less than 80%, there arises a problem that a display brightness is small.

If the liquid layer has refractive index characteristics of 1.30 or more and 1.52 or less, a capacitive coupling type touch panel excellent in display performance when combined with a display device can be realized.

By combining the above-mentioned capacitive coupling type touch panel adapted for a pen input function of one or more embodiments of the present invention with a display device such as a liquid crystal display device, a display device having a function of detecting a position touched with a pen can be realized.

At this time, a display device capable of detecting a position when touched with a resin pen or other insulators can be realized.

Further, a display device having the capacitive coupling type touch sensor function of one or more embodiments of the present invention may include a display device and a transparent substrate provided at a position isolated from and opposed to the display device. The display device having the capacitive coupling type touch sensor function of one or more embodiments of the present invention includes a capacitive coupling type touch sensor electrode circuit formed of an XY-position coordinate electrode that detects an XY-position coordinate on a transparent substrate opposed to the display device. The display device may also include a floating electrode at a position isolated from and opposed to the touch sensor electrode circuit on the display device. At this time, the XY-position coordinate electrode and the floating electrode are allowed to approach each other due to the load occurring when the transparent substrate having the touch sensor electrode circuit is touched with a pen, whereby capacitive coupling occurs between the XY-position coordinate electrode and the floating electrode. A position touched with a pen can be detected by detecting the position where the capacitive coupling occurs. Therefore, even when the transparent substrate is touched with a resin pen or other insulators, a change in a capacitance can be caused between the touched position and the position detection electrode.

The XY-position coordinate electrode may be made of a transparent conductive material, and an oxide transparent conductive material is suitable as the transparent conductive material. An indium tin oxide film, an indium zinc oxide film, or a zinc oxide film can be used for the oxide transparent conductive material. These films have a certain high level of conductivity and have a function of transmitting visible light.

Though the floating electrode may be made of a conductive material, a particularly highly conductive material is not required for the floating electrode. As the conductive material, an oxide transparent conductive material such as an indium tin oxide film, an indium zinc oxide film, or a zinc oxide film can be used. Further, as the conductive material, a conductive material of an organic compound can also be used. As the organic conductive material, there may be used polyacetylene, polyazulene, polyphenylene, polyphenylenevinylene, polyacene, polyphenylacetylene, polydiacetylene, polyaniline, polyethylenedioxythiophene, polythiophene, polyisothianaphthene, polypyrrole, or the like.

As the display device, an organic electroluminescence display device can be used, which includes a substrate with a light-emitting element in which an organic electroluminescence layer is formed between electrode layers and has a top-emission structure which takes light emitted from the light-emitting element outside of the display device through a transparent substrate.

The display device and the transparent substrate may be provided at positions isolated from each other with a space layer interposed therebetween, and the display device and the transparent substrate are allowed to approach each other via the space layer due to the load that occurs when touched with a pen. Thus, capacitive coupling occurs between the floating electrode and the XY-position coordinate electrode, whereby the position touched with a pen can be detected by a capacitive coupling type touch sensor.

The space layer having a thickness of 5 µm or more and 120 µm or less is suitable. Where the space layer has a thickness of less than 5 µm, the capacitive coupling that occurs before the approach of the floating electrode and the XY-position coordinate electrode becomes a signal noise so that N is large, resulting in a small S/N ratio, which makes it difficult to detect a position signal. Where the space layer has a thickness of 120 µm or more, the floating electrode and the XY-position coordinate electrode are not allowed to approach each other sufficiently by a small load, and S cannot be increased because the capacitance of the occurring capacitive coupling is small, resulting in a small S/N ratio, which makes it difficult to detect a position signal.

Further, the display device and the transparent substrate may be provided at positions isolated from each other with a resin layer interposed therebetween, and the display device and the transparent substrate are allowed to approach each other via the resin layer due to the load occurring when touched with a pen. Thus, capacitive coupling occurs between the floating electrode and the XY-position coordinate electrode, whereby the position touched with a pen can be detected by a capacitive coupling type touch sensor. The resin layer with a thickness of 5 µm or more and 120 µm or less is also suitable at this time.

An example of the material for a resin includes a silicone gel material. The silicone gel is an addition polymerization type silicone resin obtained by adding silicone oil to a monomer of silicone rubber due to the action of a platinum catalyst or the like, followed by curing at a cross-linking density of 1/5 to 1/10 of that of an ordinary silicone elastomer. The rubber material generally has a repulsion modulus of elasticity which varies remarkably depending upon a change in temperature due to the dependence of physical properties on the temperature, and becomes hard at a low temperature of about -10°C and has load deforming characteristics decreased. Further, rubber has large permanent compression set (residual compression set). When the rubber is supplied with a load for a long period of time, the rubber is reduced in volume, which makes it difficult to maintain load deforming characteristics. In contrast, the gel material can obtain satisfactory load deforming characteristics with almost constant mechanical properties (Young's modulus, which can also be referred to as softness) even in an environment of about -50°C to 200°C. Further, the gel material has a small residual compression set, and, hence, can maintain satisfactory load deforming characteristics for a long period of time. The silicone gel material has high light transmittance in a visible light region and can maintain light transmittance characteristics of 80% or more. Further, the silicone gel material, which has the refractive index characteristics of 1.30 or more and 1.52 or less, can realize a display device that is excellent in display performance.

The claims, the drawings and the below description of the embodiments of the invention disclose further characterizing features of the invention. The embodiments of the invention are particular combinations of the features of the invention which do not limit the scope of the invention as defined in the independent claim in any was. The skilled person will easily be able to find other combinations or sub-combinations of these features in order to adapt the invention to his specific needs without leaving the scope of the invention as defined in the independent claim.

### BRIEF DESCRIPTION OF THE DRAWINGS

FIG. 1 is a cross-sectional view illustrating a touch panel device of Embodiment 1 of the present invention.
FIG. 2 is a perspective view illustrating a liquid crystal display device with a touch panel of Embodiment 2 of the present invention.
FIG. 3 is a cross-sectional view illustrating a touch panel device of Embodiment 3 of the present invention.
FIG. 4 is a plan view illustrating a substrate of a touch panel device of Embodiment 4 of the present invention.
FIG. 5 is a plan view illustrating a substrate of a touch panel device of Embodiment 5 of the present invention.
FIG. 6 is a cross-sectional view illustrating a touch panel device of Embodiment 6 of the present invention.
FIG. 7 is a cross-sectional view illustrating a touch panel device of Embodiment 7 of the present invention.
FIG. 8 is a cross-sectional view illustrating a touch panel device of Embodiment 8 of the present invention.
FIGS. 9A and 9B are a plan view and a cross-sectional view each illustrating a connection terminal portion of a touch panel device of Embodiment 9 of the present invention.
FIGS. 10A and 10B are a plan view and a cross-sectional view each illustrating a frame portion of a touch panel device of Embodiment 10 of the present invention.
FIGS. 11A and 11B are a plan view and a cross-sectional view each illustrating a frame portion of a touch panel device of Embodiment 11 of the present invention.
FIG. 12 is a cross-sectional view illustrating a touch panel device of Embodiment 12 of the present invention.
FIG. 13 is a cross-sectional view illustrating a touch panel device of Embodiment 13 of the present invention.
FIG. 14 is a cross-sectional view illustrating a display device according to Embodiment 14 of the present invention.
FIG. 15 is a cross-sectional view illustrating a display device according to Embodiment 15 of the present invention.
FIG. 16 is a cross-sectional view illustrating a display device according to Embodiment 16 of the present invention.
FIG. 17 is a cross-sectional view illustrating a display device according to Embodiment 17 of the present invention.
FIG. 18 is a plan view illustrating a configuration of a light-emitting substrate surface according to the display device with the configuration illustrated in FIG. 14.
FIG. 19 is a plan view illustrating a configuration of a light-emitting substrate surface according to the display device with the configuration illustrated in FIG. 15.
FIG. 20 is a cross-sectional view illustrating a display device according to Embodiment 20 of the present invention.

### DETAILED DESCRIPTION OF THE INVENTION

As described above, generally, a capacitive coupling type touch panel detects a position by grasping a change in a capacitance between a finger tip and a position detection electrode. Therefore, when the touch panel is touched with a perfect insulator, surface static electricity is unlikely to change, and hence a position cannot be detected. Therefore, when the touch panel is touched with a resin pen or other insulators, a capacitance is not changed between the resin pen or other insulators and the position detection electrode, which makes it impossible to perform an input.

An object of one or more embodiments of the present invention is to provide a capacitive coupling type touch panel capable of detecting a position when touched with a rein pen or other insulators by utilizing the advantage of the capacitive coupling type touch panel that detects a touched position at a high speed.

An object of one or more embodiments of the present invention is to provide a capacitive coupling type touch panel adapted for a pen input function for detecting a position when touched with a resin pen or other insulators, and a display device having a function for detecting a position touched with a pen, in which the capacitive coupling type touch panel adapted for the pen input function and a display device are combined with each other.

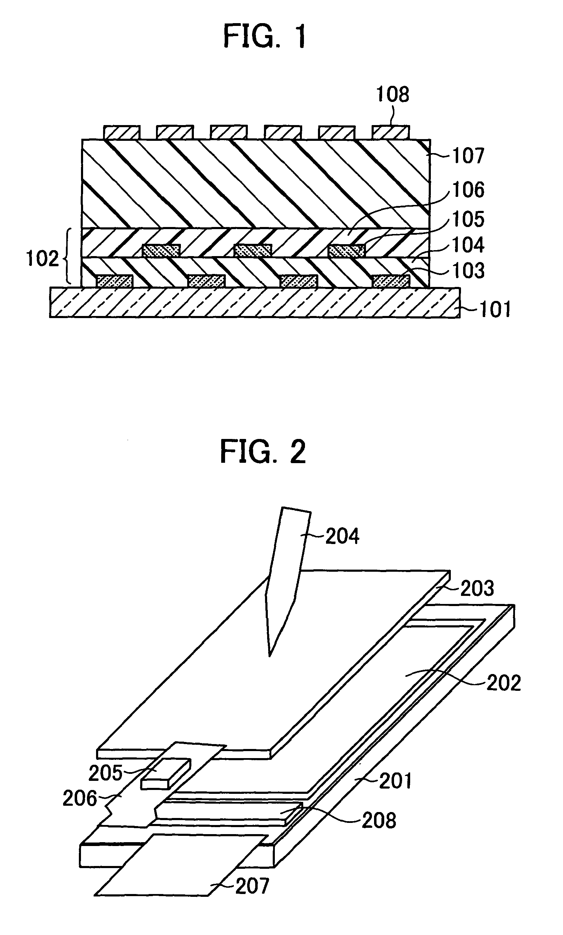

Hereinafter, one or more embodiments of the present invention is described with reference to FIGS. 1 to 20.

### [Embodiment 1]

A touch panel device of Embodiment 1 illustrated in the cross-sectional view of FIG. 1 is produced under the following conditions.

In the touch panel device of this embodiment, a coordinate detection circuit layer 102 that detects a position coordinate is formed on one surface of a transparent substrate 101. In the circuit layer, transparent electrodes to be coordinate electrodes 103 and 105 are placed via insulating films 104 and 106.

As the transparent substrate 101, a glass substrate made of alkali glass such as soda glass or borosilicate glass, non-alkali glass, or chemically strengthened glass is suitable. In addition, polyester films having transparency such as polyethylene terephthalate and polyethylene naphthalate and polyimide films having high heat resistance and high transparency are also known, and such resin-based substrate having transparency may also be used.

As the transparent electrodes to be the coordinate electrodes 103 and 105, oxide transparent electrodes such as an indium tin oxide film, an indium zinc oxide film, or zinc oxide having a certain high level of conductivity and having a function of transmitting visible light are suitable.

The thickness of the coordinate electrode is arbitrarily set based on the correlation between the conductivity and the transparency. Further, the shape of the coordinate electrode is arbitrarily set so as to obtain performance capable of detecting a position signal satisfactorily from the ratio between a signal of capacitive coupling and a noise as a detection circuit.

The coordinate electrodes 103 and 105 respectively become coordinate electrodes corresponding to an X-position coordinate and a Y-position coordinate in a touch panel device. It is not necessary that the upper and lower relationship of the coordinate electrodes 103 and 105 is set to be XY. That is, the coordinate electrode 103 may be set to be an X-position coordinate electrode that detects an X-position, and the coordinate electrode 105 may be set to be a Y-position coordinate electrode that detects a Y-position. Also, the coordinate electrode 103 may be set to be a Y-position coordinate electrode that detects a Y-position, and the coordinate electrode 105 may be an X-position coordinate electrode that detects an X-position.

The transparent electrodes to become the coordinate electrodes 103 and 105 are realized by, for example, forming an indium tin oxide film with a thickness of 5 to 100 nm by well-known sputtering in vacuum. Next, a photoresist is applied to the film, followed by exposure and development, using well-known photolithography, whereby a desired coordinate electrode pattern is formed. Next, using the photoresist pattern obtained accordingly as a mask, a transparent electrode is patterned by etching, and the photoresist is removed, whereby a desired coordinate electrode pattern made of a transparent electrode is obtained.

When the indium tin oxide film is etched, an acidic solution such as a hydrobromic acid solution may be used as an etchant.

As the insulating films 104 and 106, an insulating filmmaterial with light transmittance is suitable. The film thickness can be selected considering the light transmittance and the dielectric constant of the insulating film material. In the case where the insulating film is set to have a specific dielectric constant of 3 to 4, the film thickness of 1 to 20 µm is suitable.

As a material for the insulating film layer, a photosensitive material is used because it is suitable for forming an opening pattern for forming the above-mentioned coordinate detection circuit layer 102. A positive photosensitive material and a negative photosensitive material are known. By combining an acrylic resin, an acrylic epoxy-based resin, or a siloxane-based resin as a base polymer with a photosensitive agent, the positive photosensitive material develops, dissolves, and removes a portion irradiated with light, and the negative photosensitive material develops, dissolves, and removes a portion not irradiated with light As a developing solution, an alkali aqueous solution or an organic solvent can be used depending upon each photosensitive material.

It is necessary that the insulating film has light transmittance of 80% or more in order not to decrease the performance of an image display device. In the above-mentioned insulating film material, where components such as a base polymer and a photosensitive agent having small light absorption in a visible light region (400 nm to 800 nm) are selected as the negative photosensitive material, the insulating film material can realize light transmittance. Further, in the positive photosensitive material, a base polymer having small light absorption in a visible light region is selected, and a photosensitive agent is subjected to photo-bleaching, whereby the light transmittance in a visible light region can be enhanced.

Specifically, the coordinate detection circuit layer 102 can be formed in the following steps.

An indium tin oxide film is formed to have a thickness of 20 nm over the entire surface of the transparent substrate 101, using sputtering. Then, a photoresist is applied, followed by exposure and development, and a desired pattern with indium tin oxide of the lower layer exposed is formed, by well-known photolithography. Next, using the photoresist pattern as a mask, the exposed indium tin oxide is removed by etching using a hydrobromic acid aqueous solution. Then, the photoresist is removed to obtain the desired coordinate electrodes 103 made of transparent electrodes.

In the formation of an insulating film layer in the case of using an acrylic negative photosensitive material that can be developed with an alkali aqueous solution, the following steps are taken. First, a material solution is applied to the transparent substrate 101 on which the coordinate electrodes 103 are formed. Then, the material solution is heated at 90°C for 5 minutes with a hot plate to obtain a prebaked film. The surfaceexcept for a portion to be opened as an insulating film is irradiated with light via a photomask for forming a desired pattern, to thereby be cured optically. Then, the prebaked film is developed using an alkali aqueous solution of 2.38 wt% tetramethyl ammonium hydroxide, and a portion not irradiated with light is dissolved to be removed, whereby a desired opening is formed in the insulating film. Then, the film is heated to be cured at 230°C for 10 minutes with a hot plate to obtain the insulating film 104 with a thickness of 2 µm.

Next, an indium tin oxide film is formed to have a thickness of 20 nm over the entire surface of the transparent substrate 101 including the insulating film 104 thereon, using sputtering. Then, a photoresist is applied, followed by exposure and development, and a desired pattern with indium tin oxide of the lower layer exposed is formed, by well-known photolithography. Next, using the photoresist pattern as a mask, the exposed indium tin oxide is removed by etching using a hydrobromic acid aqueous solution. Then, the photoresist is removed to obtain the desired coordinate electrodes 105 made of transparent electrodes.

Next, on the substrate on which the coordinate electrode layer of the lower layer is formed, an acrylic negative photosensitive material solution that can be developed with an alkali aqueous solution is applied. Then, the material solution is heated at 90°C for 5 minutes with a hot plate to obtain a prebaked film. The surface except for a portion to be opened as an insulating film is irradiated with light via a photomask for forming a desired pattern, to thereby be cured optically. Then, the prebaked film is developed using an alkali aqueous solution of 2.38 wt% tetramethyl ammonium hydroxide, and a portion not irradiated with light is dissolved to be removed, whereby a desired opening is formed in the insulating film. Then, the film is heated to be cured at 230°C for 10 minutes with a hot plate to obtain the insulating film 106 with a thickness of 2 µm.

Then, a load deforming insulating film 107 that is deformed due to a touch load of a pen input is formed on the coordinate detection circuit layer 102. The insulating film 107 has a thickness of 10 µm or more and 120 µm or less. The load deforming insulating film has important characteristics of being deformed due to the touch load, and recovering from the deformation due to the removal of the load.

As a material for the load deforming insulating film 107, a silicone gel material is preferred. The silicone gel is an addition polymerization type silicone resin obtained by adding silicone oil to a monomer of silicone rubber due to the action of a platinum catalyst or the like, followed by curing at a cross-linking density of 1/5 to 1/10 of that of an ordinary silicone elastomer.

The rubber material generally has a repulsion modulus of elasticity which varies remarkably depending upon a change in temperature due to the dependence of physical properties on the temperature, and becomes hard at a low temperature of about -10°C and has load deforming characteristics decreased. Further, rubber has large permanent compression set (residual compression set). When the rubber is supplied with a load for a long period of time, the rubber becomes loose, which makes it difficult to maintain load deforming characteristics.

In contrast, the gel material can obtain satisfactory load deforming characteristics with almost constant mechanical properties (Young's modulus, which can also be referred to as softness) even in an environment of about -50°C to 200°C. Further, the gel material has a small residual compression set, and hence can maintain satisfactory load deforming characteristics for a long period of time.

The silicone gel material has high light transmittance in a visible light region and can maintain light transmittance characteristics of 80% or more.

Further, the silicone gel material can realize a capacitive coupling type touch panel excellent in display performance when combined with a display device due to the refractive index characteristics of 1.30 or more and 1.52 or less.

In this case, a silicone gel is formed to have a thickness of 100 µm to obtain the load deforming insulating film 107. At this time, the silicone gel load deforming insulating film is deformed by 50% of its thickness with a load of 82 g of a pen touch. Further, the load deforming insulating film 107 has a refractive index of 1.4 and a light transmittance of 98% or more at a wavelength of 400 to 800 nm.

A floating electrode 108 is formed. As the floating electrode, an oxide transparent electrode such as an indium tin oxide film, an indium zinc oxide film, or zinc oxide that has a function of transmitting visible light issuitable. By forming an oxide material into a film with a thickness of 5 to 100 nm via a metal mask with a desired opening formed therein by sputtering, a desired floating electrode 108 is obtained.

Further, as such an oxide electrode, a coating material in which fine particles of a transparent oxide conductive material are dispersed in a solution can be used. A desired pattern is formed from such a coating material by a well-known inkj et coating technique or screen printing technique, and a volatile component such as a solvent is removed by heating and sintering at 100°C to 230°C to obtain a transparent oxide conductive pattern, whereby the floating electrode 108 is obtained.

In this case, an indium tin oxide with a thickness of 15 nm is formed via a metal mask with a desired opening formed therein by sputtering to obtain the floating electrode 108.

The capacitive coupling type touch panel device illustrated in the cross-sectional view of FIG. 1 is obtained using the material configurations and steps described above.

Thus, due to the configuration in which the floating electrode is present opposed to the position coordinate electrode circuit via the load deforming insulating film, the floating electrode is pressed with a touch load of 82 g of a resin pen, the load deforming insulating film is deformed by 50% of its thickness, the floating electrode and the XY-position coordinate electrode are allowed to approach each other, capacitive coupling occurs between the floating electrode and the XY-position coordinate electrode, and the position touched with a pen can be detected, whereby a capacitive coupling type touch panel adapted for a pen input function is obtained.

### [Embodiment 2]

A liquid crystal display device with a touch panel of Embodiment 2 illustrated in FIG. 2 is produced under the following conditions.

A touch panel 203 obtained in Embodiment 1 (FIG. 1) is laminated and fixed on a surface of a liquid crystal display device 201 opposed to a liquid crystal display region 202. The touch panel 203 is connected to a flexible printed wiring board 206 with a touch panel position detecting circuit control IC 205 mounted thereon. The flexible printed wiring board 206 connects the touch panel 203 to the liquid crystal display device 201 for the purpose of inputting a signal to the liquid crystal display device 201. A liquid crystal display control IC 208 is mounted on the liquid crystal display device 201, and a flexible printed wiring board 207 is connected thereto. The flexible printed wiring board 207 is connected to, for example, a signal circuit of a mobile phone, thereby sending a display image signal to the liquid crystal display device 201.

In the touch panel device obtained in Embodiment 1, due to the configuration in which the floating electrode is present opposed to the position coordinate electrode circuit via the load deforming insulating film, the floating electrode is pressed with a touch load of 82 g of a resin pen, the load deforming insulating film is deformed by 50% of its thickness, the floating electrode and the XY-position coordinate electrode are allowed to approach each other, capacitive coupling occurs between the floating electrode and the XY-position coordinate electrode, and the position touched with a pen can be detected, whereby a display device having a function of detecting a position touched with a pen is obtained in which the capacitive coupling type touch panel adapted for a pen input function is combined with a display device.

In this embodiment, though the touch panel device obtained in Embodiment 1 is used, touch panel devices obtained in embodiments described later may be similarly used.

### [Embodiment 3]

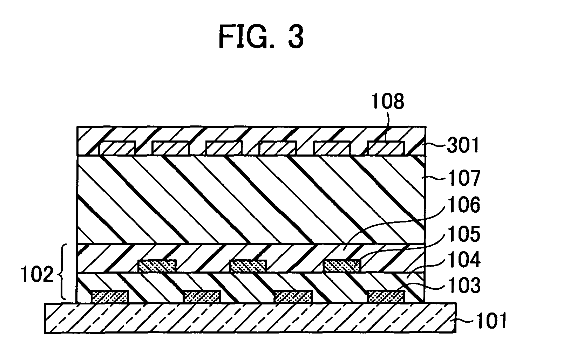

A touch panel device of Embodiment 3 illustrated in FIG. 3 is produced under the following conditions.

A surface protective layer 301 is formed on the outermost surface of the touch panel obtained in Embodiment 1 (FIG. 1).

As a material for the protective layer, an insulating film material with light transmittance that is used for the insulating films 104 and 106 in Embodiment 1 is suitable.

Further, in addition to the above-mentioned photosensitive material, a thermosetting material is also suitable in which only a thermosetting material is combined with a base polymer including an acrylic resin, an acrylic epoxy-based resin, or a siloxane-based resin.

Further, a glass substrate made of alkali glass such as soda glass or borosilicate glass, non-alkali glass, or chemically strengthened glass can be attached to be used as the surface protective layer 301. Further, a resin-based substrate having transparency, such as a polyester film made of polyethylene terephthalate or polyethylene naphthalate having transparency, or a polyimide film having high heat resistance and high transparency can be attached to be used as the surface protective layer 301.

Thus, due to the configuration in which the floating electrode is present opposed to the position coordinate electrode circuit via the load deforming insulating film, the floating electrode is pressed with a touch load of a resin pen, the thickness of the load deforming insulating film is deformed, the floating electrode and the XY-position coordinate electrode are allowed to approach each other, capacitive coupling occurs between the floating electrode and the XY-position coordinate electrode, and the position touched with a pen can be detected, whereby a capacitive coupling type touch panel adapted for a pen input function is obtained.

### [Embodiment 4]

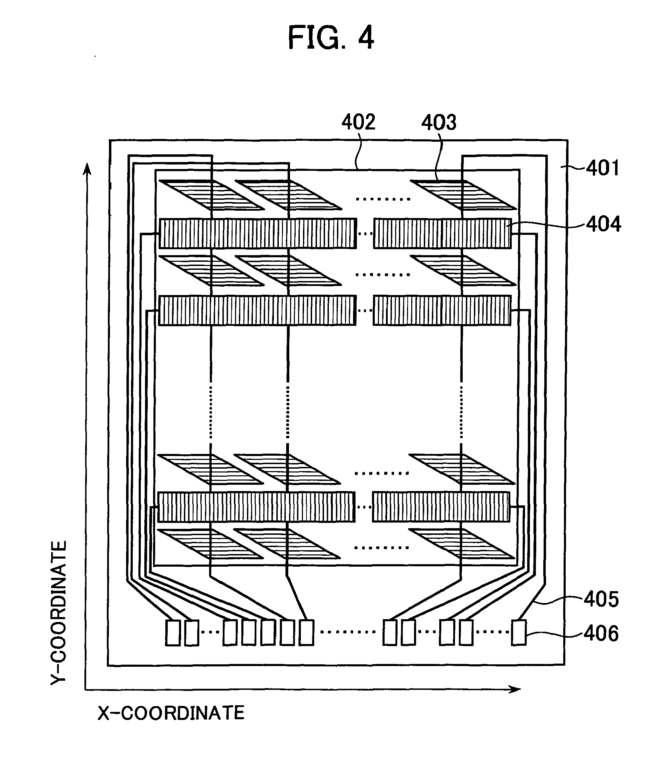

A touch panel device of Embodiment 4 illustrated in the substrate plan view of FIG. 4 is produced under the following conditions.

An X-position coordinate electrode 403 is formed on a transparent substrate 401 using the material and step of forming the coordinate electrode 103 described in Embodiment 1 (FIG. 1). Then, an insulating film 104 (not illustrated in FIG. 4) is formed using the material and step described in Embodiment 1.

Next, a Y-position coordinate electrode 404 is formed using the material and step of forming the coordinate electrode 105 described in Embodiment 1.

The shapes of the X-position coordinate electrode 403 and the Y-position coordinate electrode 404 can be selected so that the floating electrode is pressed due to a load at a time of a pen touch, the insulating film is deformed in a thickness direction due to the load, the floating electrode and the XY-position coordinate electrode are allowed to approach each other, and capacitive coupling occurs between the floating electrode and the XY-position coordinate electrode, whereby a position signal is detected satisfactorily before and after the approach of the floating electrode and the XY-position coordinate electrode.

In this embodiment, though the X-position coordinate electrode 403 has a diamond shape and the Y-position coordinate electrode 404 has a rectangular shape, the X-position coordinate electrode may have a rectangular shape and the Y-position coordinate electrode may have a diamond shape.

The X-position coordinate electrode 403 and the Y-position coordinate electrode 404 are connected to electrode circuit signal wiring 405 on the periphery of the coordinate detection surface 402 of the touch panel substrate, and the electrode circuit signal wiring is drawn out to a connection terminal opening 406. The connection terminal opening is connected to the flexible printed circuit board on which the touch panel position detection circuit control IC as illustrated in FIG. 2 is mounted.

In this embodiment, the substrate plan view of the touch panel device of Embodiment 1 and the production thereof are described. However, the substrate plan views of the touch panel devices of Embodiment 3 described above and Embodiments 6, 7, 8, 12, and 13 described later and the production thereof can be described similarly.

### [Embodiment 5]

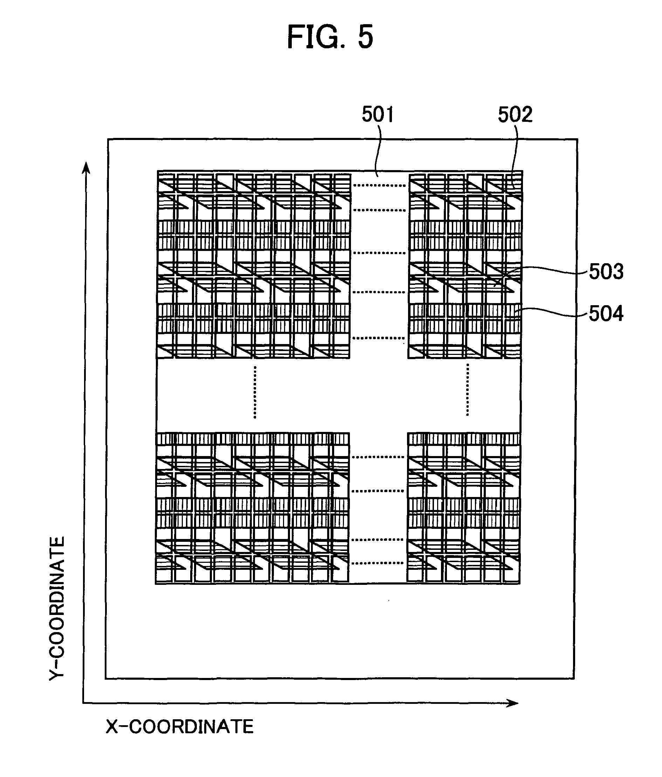

A touch panel device of Embodiment 5 illustrated in the substrate plan view of FIG. 5 is produced under the following conditions.

An X-position coordinate electrode 503 and a Y-position coordinate electrode 504 are present on a coordinate detection surface 501. Those electrodes are obtained as described in Embodiment 4 (FIG. 4).

In this embodiment, the X-position coordinate electrode 503 has a diamond shape and the Y-position coordinate electrode 504 has a rectangular shape.

In this case, a floating electrode 502 has a shape independently divided into a small rectangle corresponding to the above-mentioned electrodes. The rectangular floating electrode 502 divided independently is placed so as to overlap the diamond-shaped X-position coordinate electrode 503 and the rectangular Y-position coordinate electrode 504.

Thus, due to the configuration in which the floating electrode is present opposed to the position coordinate electrode circuit via the load deforming insulating film, the floating electrode is pressed with a touch load of a resin pen, the thickness load deforming insulating film is deformed, the floating electrode and the XY-position coordinate electrode are allowed to approach each other, capacitive coupling occurs between the floating electrode and the XY-position coordinate electrode, and the position touched with a pen can be detected, whereby a capacitive coupling type touch panel adapted for a pen input function is obtained.

Although the X-position coordinate electrode 503 has a diamond shape and the Y-position coordinate electrode 504 has a rectangular shape in this embodiment, the X-position coordinate electrode may have a rectangular shape and the Y-position coordinate electrode may have a diamond shape. Further, as long as the X-position coordinate electrode and the Y-position coordinate electrode are placed so as to overlap one independent floating electrode, the X-position coordinate electrode, the Y-position coordinate electrode, and the floating electrode may have different shapes.

In this embodiment, the substrate plan view of the touch panel device of Embodiment 4 using the touch panel device of Embodiment 1 and the production thereof are described. However, the touch panel devices of Embodiment 3 described above, and Embodiments 6, 7, 8, 12, and 13 described later can be used similarly.

### [Embodiment 6]

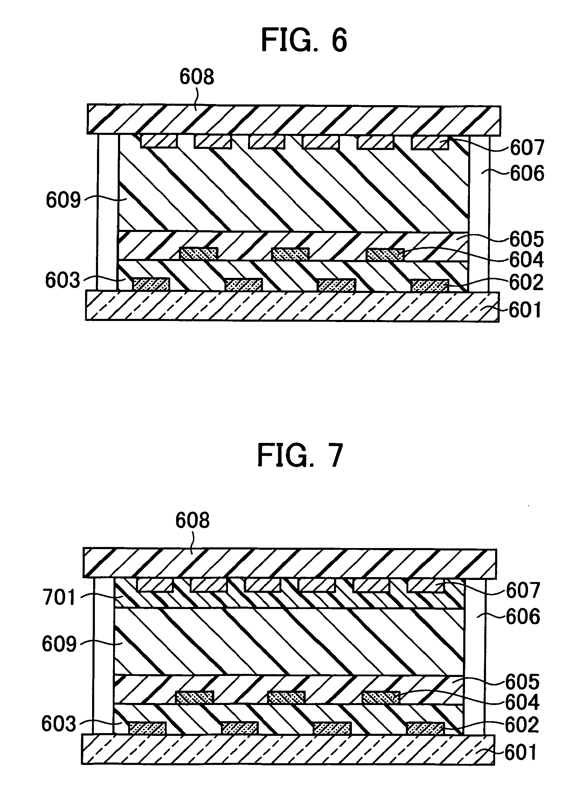

A touch panel device of Embodiment 6 illustrated in the cross-sectional view of FIG. 6 is produced under the following conditions.

In this case, a gas layer is used instead of a load deforming insulating film with respect to the touch panel device of Embodiment 3 (FIG. 3).

Using the materials and steps described in Embodiment 1, coordinate electrodes 602, 604 and insulating films 603, 605 are formed on a transparent substrate 601 to obtain an X-position coordinate electrode and a Y-position coordinate electrode.

An adhesive is applied to the periphery of the coordinate detection surface of the touch panel substrate to forma frame adhesive portion 606.

A transparent substrate 608 with floating electrodes 607 formed thereon is attached to the frame adhesive portion 606. At this time, the floating electrodes 607 are placed so as to correspond to the X-position coordinate electrodes and the Y-position coordinate electrodes as illustrated in Embodiment 5 (FIG. 5).

The frame adhesive portion 606 is obtained by forming a highly viscous adhesive with a thermosetting property or with a combination of a thermosetting property and a light-curable property so as to have the thickness of 10 µm or more and 120 µm or less. Glass in a spherical or fiber shape having a diameter of 10 µm or more and 120 µm or less is kneaded as a so-called gap agent with the adhesive, and the thickness of the frame adhesive portion 606 is controlled by the thickness of the glass.

As the transparent substrate 608 with the floating electrodes 607 formed thereon, a glass substrate made of alkali glass such as soda glass or borosilicate glass, non-alkali glass, chemically strengthened, a resin-based substrate having transparency, such as a polyester film made of polyethylene terephthalate or polyethylene naphthalate having transparency, or a polyimide film having high heat resistance and transparency can be used.

Using a substrate with a thickness of 0.4 mm of non-alkali glass as a transparent substrate, an indium tin oxide film is formed to have the thickness of 15 nm by sputtering. Then, a photoresist is applied to the film, followed by exposure and development, using well-known photolithography, whereby a desired pattern with indium tin oxide in the lower layer exposed is formed. Next, using the photoresist pattern as a mask, the exposed indium tin oxide is removed by etching using a hydrobromic acid aqueous solution. Then, the photoresist is removed to obtain the floating electrodes 607.

Next, the reverse surface of the transparent substrate 608 with the floating electrodes 607 formed thereon is polished to have the thickness of 0.2 mm, whereby a transparent substrate with a thickness of 0.2 mm is obtained. For the polishing, a chemical polishing technology of etching glass using a chemical solution or a mechanical polishing technology of grinding mechanically using abrasive grains as a polishing agent.

A thermosetting adhesive in which glass beads having a diameter of 100 µm are kneaded is applied to the periphery of the coordinate detection surface of the touch panel substrate, whereby the frame adhesive portion 606 is formed. The glass substrate having a thickness of 0.2 mm with the floating electrodes formed thereon is attached to the frame adhesive portion 606. At this time, the floating electrodes 607 are placed so as to correspond to the X-position coordinate electrodes and the Y-position coordinate electrodes via a space of 100 µm as illustrated in Embodiment 5. Then, the adhesive is cured by heating at 140°C for 60 minutes. Thus, the touch panel device illustrated in the cross-sectional view of FIG. 6 is obtained.

Thus, due to the configuration in which the floating electrode 607 is present opposed to the position coordinate electrode circuit via the gas layer (space layer 609), the floating electrode is pressed with a touch load of a resin pen, the gas layer is deformed, the floating electrode and the XY-position coordinate electrode are allowed to approach each other, capacitive coupling occurs between the floating electrode and the XY-position coordinate electrode, and the position touched with a pen can be detected, whereby a capacitive coupling type touch panel adapted for a pen input function is obtained.

In the case of using the gas layer, it is possible that the floating electrodes 607 approaches the insulating film 605 so as to eliminate the thickness of the layer, i.e. so as to come into contact with the insulating film 605, under a low load. When capacitive coupling occurs between the floating electrodes and the XY-position coordinate electrodes, a large ratio between a signal of the capacitive coupling and a noise can be taken before and after the approach of the floating electrodes and the XY-position coordinate electrodes, whereby a position signal can be detected satisfactorily.

### [Embodiment 7]

A touch panel device of Embodiment 7 illustrated in the cross-sectional view of FIG. 7 is produced under the following conditions.

A floating electrode protective film 701 is formed on the surface of a glass substrate on which floating electrodes obtained in Embodiment 6 (FIG. 6) are formed.

As the material for the floating electrode protective layer 701, an insulating film material with light transmittance used in the insulating films 104 and 106 in Embodiment 1 is suitable. Further, in addition to the above-mentioned photosensitive material, a thermosettingmaterial is also suitable in which only a thermosetting material is combined with a base polymer of an acrylic resin, an acrylic epoxy-based resin, or a siloxane-based resin.

Thus, due to the configuration in which the floating electrode is present opposed to the position coordinate electrode circuit via the gas layer, the floating electrode is pressed with a touch load of a resin pen, the gas layer is deformed, the floating electrode and the XY-position coordinate electrode are allowed to approach each other, capacitive coupling occurs between the floating electrode and the XY-position coordinate electrode, and the position touched with a pen can be detected, whereby a capacitive coupling type touch panel adapted for a pen input function is obtained.

In the case of using the gas layer, it is possible that the floating electrodes approach the insulating film of the XY-position coordinate electrodes so as to eliminate the thickness of the layer, i.e. so as to come into contact with the insulating film, under a low load. Due to the floating electrode protective layer 701, the effect of protecting the floating electrode itself is obtained.

### [Embodiment 8]

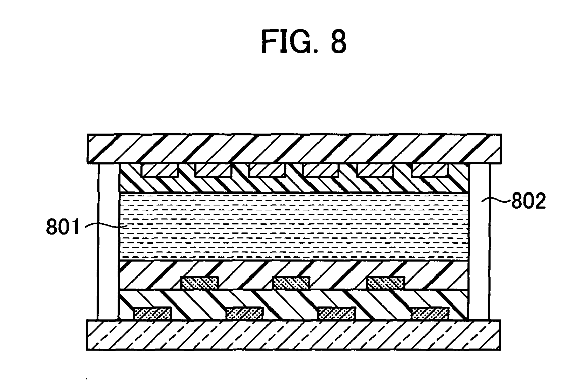

A touch panel device of Embodiment 8 illustrated in the cross-sectional view of FIG. 8 is produced under the following conditions. In this case, a liquid crystal layer is used in place of an air layer with respect to the touch panel device described in Embodiment 6 (FIG. 6).

In this case, a light-curable adhesive with glass beads having a diameter of 100 µm kneaded therein is applied to the periphery of the coordinate detection surface of the touch panel substrate, whereby a frame sealing adhesive layer 802 having a thickness of 100 µm is formed.

Flowing paraffin is dropped to fill the frame adhesive portion, and a glass substrate having a thickness of 0.2 mm with the floating electrodes formed thereon described in Embodiment 6 is attached to the frame sealing adhesive layer 802. At this time, the floating electrodes are placed so as to correspond to the X-position coordinate electrodes and the Y-position coordinate electrodes via a space of 100 µm as illustrated in Embodiment 5 (FIG. 5). After that, the adhesive is cured by irradiation with light. Thus, a touch panel device having a liquid layer 801 filled with the flowing paraffin is obtained.

Here, as the flowing paraffin, hydrocarbon-based or silicone oil-based colorless transparent liquid materials with a dielectric constant of 1.9 to 3. 0 are preferably used. Further, materials with a dielectric constant of 1.9 to 2.5 are more preferably used.

Thus, due to the configuration in which the floating electrode is present opposed to the position coordinate electrode circuit via the transparent liquid layer 801, the floating electrode is pressed with a touch load of a resin pen, the liquid layer is deformed, the floating electrode and the XY-position coordinate electrode are allowed to approach each other, capacitive coupling occurs between the floating electrode and the XY-position coordinate electrode, and the position touched with a pen can be detected, whereby a capacitive coupling type touch panel adapted for a pen input function is obtained.

In the case of using the liquid layer, it is possible that the floating electrodes approach the insulating film of the XY-position coordinate electrodes so as to eliminate the thickness of the layer, i.e. so as to come into contact with the insulating film, under a low load.

### [Embodiment 9]

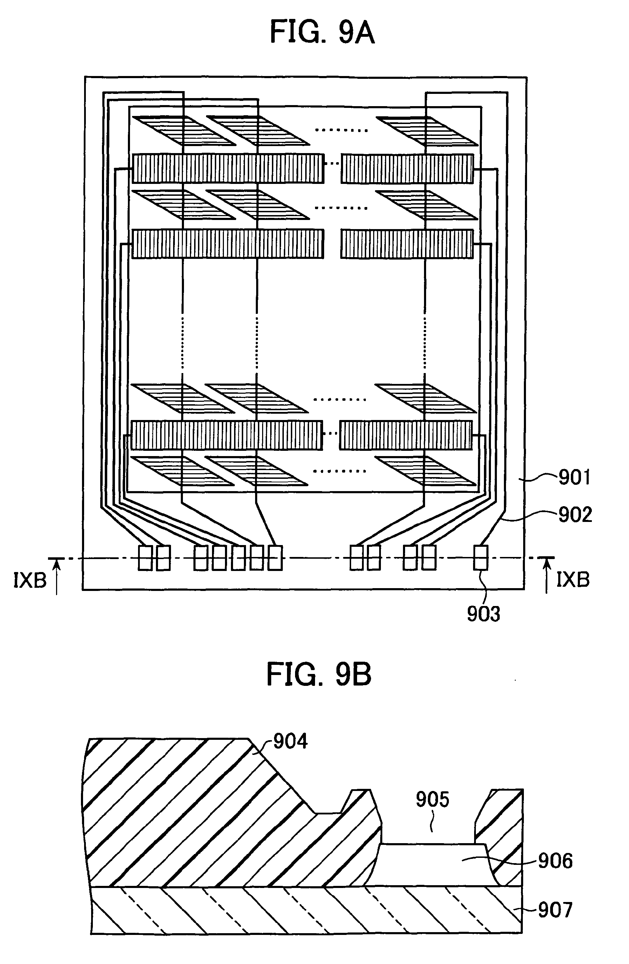

A touch panel device of Embodiment 9 illustrated in FIGS. 9A and 9B is described in detail based on the touch panel device described in Embodiment 4 (FIG. 4).

An electrode circuit signal wiring 902 is drawn out to a connection terminal opening 903 with respect to a touch panel transparent substrate 901, diamond-shaped X-position coordinate electrodes, and rectangular Y-position coordinate electrodes.

In a cross-section IXB-IXB of the connection terminal opening, when the insulating films of the X-position coordinate electrode and the Y-position coordinate electrode are formed, a connection terminal opening 905 is obtained by forming an opening with respect to an electrode circuit signal wiring 906. The material for the insulating films and the method for forming openings are described in the above embodiments.

### [Embodiment 10]

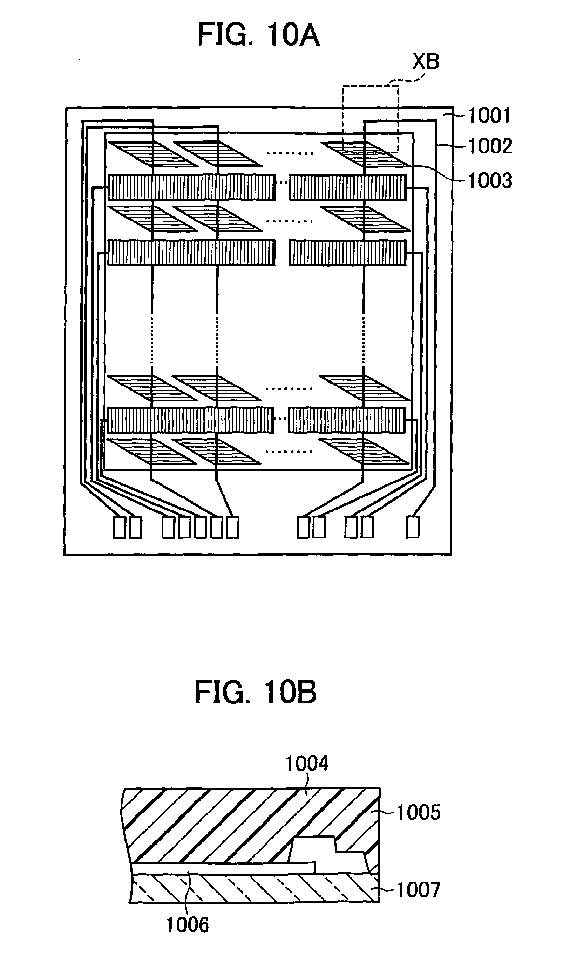

A touch panel device of Embodiment 10 illustrated in FIGS. 10A and 10B is described in detail based on the touch panel device described in Embodiment 4 (FIG. 4).

An electrode circuit signal wiring 1002 is drawn out to the periphery of a transparent substrate with respect to a touch panel transparent substrate 1001 and diamond-shaped coordinate electrodes 1003.

At this time, in a cross-section XB of the periphery of the transparent substrate, a coordinate electrode 1006 is formed on a touch panel transparent substrate 1007, and an electrode circuit signal wiring 1005 is formed thereon, and a coordinate electrode insulating film 1004 is formed thereon.

### [Embodiment 11]

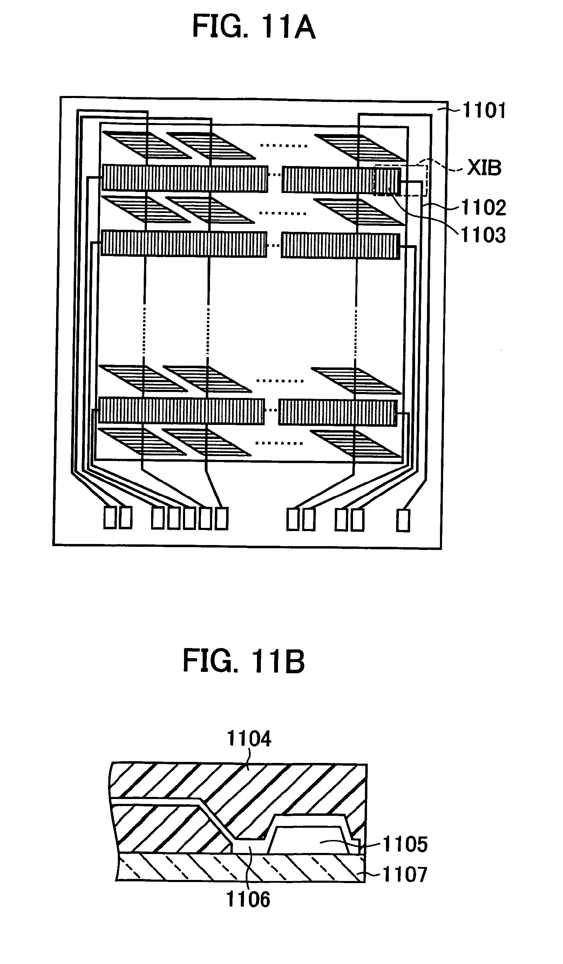

A touch panel device of Embodiment 11 illustrated in FIGS. 11A and 11B is described in detail based on the touch panel device described in Embodiment 4 (FIG. 4).

An electrode circuit signal wiring 1102 is drawn out to the periphery of a transparent substrate with respect to a touch panel transparent substrate 1101 and rectangular-shaped coordinate electrodes 1103.

At this time, in a cross-section XIB of the periphery of the transparent substrate, an electrode circuit signal wiring 1105 is formed on a touch panel transparent substrate 1107, a coordinate electrode 1106 is formed thereon, and a coordinate electrode insulating film 1104 is formed thereon.

### [Embodiment 12]

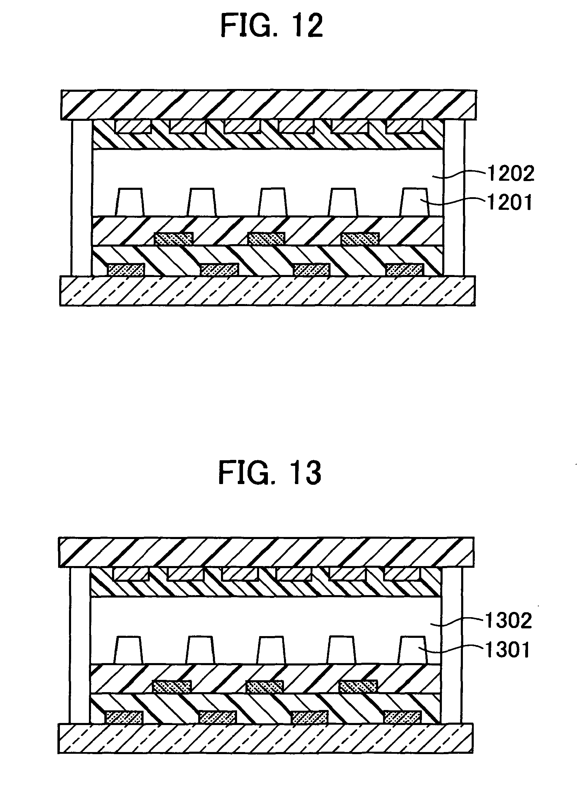

A touch panel device of Embodiment 12 illustrated in the cross-sectional view of FIG. 12 is described in detail based on the touch panel device described in Embodiment 6 (FIG. 6).

An interval thickness control projection pattern 1201 is formed on the upper surface of the coordinate detection electrode circuit layer. The interval thickness control projection pattern can be formed to have a desired thickness in a desired pattern shape using the above-mentioned photosensitive material and photolithography technology.

After that, a transparent substrate with floating electrodes formed thereon is attached using the frame adhesive portion. The floating electrodes are placed so as to correspond to the position coordinate electrodes as illustrated in Embodiment 5 (FIG. 5).

Thus, due to the configuration in which the floating electrode is present opposed to the position coordinate electrode circuit via the space layer 1202, the floating electrode is pressed with a touch load of a resin pen, the space layer is deformed, the floating electrode and the XY-position coordinate electrode are allowed to approach each other, capacitive coupling occurs between the floating electrode and the XY-position coordinate electrode, and the position touched with a pen can be detected, whereby a capacitive coupling type touch panel adapted for a pen input function is obtained.

At this time, the interval thickness control projection pattern 1201 can control the interval between the floating electrodes and the XY-position coordinate electrodes after the approach thereof, and when capacitive coupling occurs between the floating electrodes and the XY-position control electrodes, a signal amount of the capacitive coupling is controlled, whereby a position signal can be detected satisfactorily.

### [Embodiment 13]

A touch panel device of Embodiment 13 illustrated in the cross-sectional view of FIG. 13 is described in detail based on the touch panel device described in Embodiment 8 (FIG. 8).

An interval thickness control projection pattern 1301 is formed on the upper surface of the coordinate detection electrode circuit layer. The interval thickness control projection pattern can be formed to have a desired thickness in a desired pattern shape using the above-mentioned photosensitive material and photolithography technology.

After that, a frame sealing adhesive layer is formed, and flowing paraffin is dropped to fill the frame sealing adhesive layer, and a glass substrate with the floating electrodes formed thereon is attached to the frame adhesive portion.

Thus, due to the configuration in which the floating electrode is present opposed to the position coordinate electrode circuit via the space layer 1302, the floating electrode is pressed with a touch load of a resin pen, the space layer is deformed, the floating electrode and the XY-position coordinate electrode are allowed to approach each other, capacitive coupling occurs between the floating electrode and the XY-position coordinate electrode, and the position touched with a pen can be detected, whereby a capacitive coupling type touch panel adapted for a pen input function is obtained.

At this time, the interval thickness control projection pattern 1301 can control the interval between the floating electrodes and the XY-position coordinate electrodes after the approach thereof, and when capacitive coupling occurs between the floating electrodes and the XY-position control electrodes, a signal amount of the capacitive coupling is controlled, whereby a position signal can be detected satisfactorily.

### [Embodiment 14]

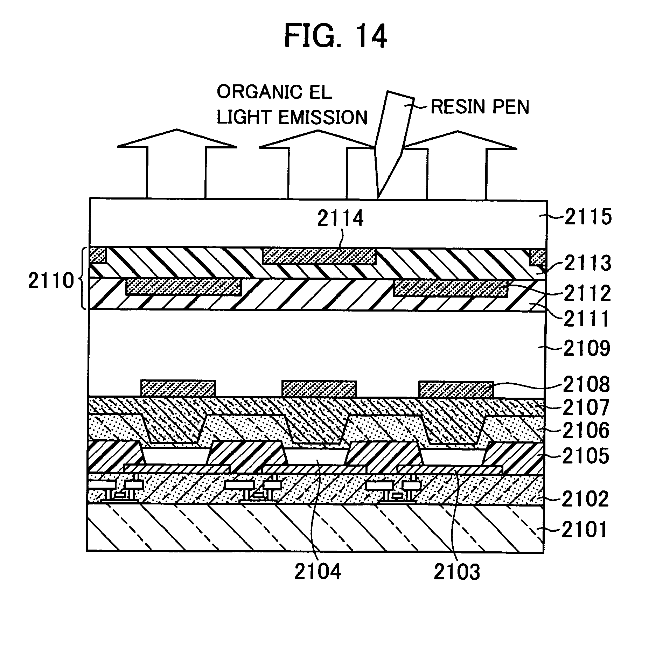

A display device containing a capacitive coupling type touch sensor of Embodiment 14 of the present invention is described with reference to the cross-sectional view of FIG. 14.

A thin film transistor circuit 2102 for displaying an image, which includes a gate electrode, a source electrode, a drain electrode, a wiring interlayer insulating layer, and the like, is provided on a substrate 2101, using a low-temperature polysilicon thin film transistor as a switching element. The thin film transistor circuit is connected electrically to an organic electroluminescence layer (hereinafter, referred to as an organic EL layer) 2104 and a lower reflective electrode 2103.

The organic EL layer 2104 is separated on a display pixel basis by a partition insulating film 2105. An upper transparent electrode 2106 is formed in an upper layer of the organic EL layer 2104, and a current is applied between the lower reflective electrode 2103 and the upper transparent electrode 2106 in response to an electric signal from the transistor circuit, and the organic EL layer 2104 emits light. At this time, the lower reflective electrode 2103 also has a function of reflecting organic EL light, and thus, the display device is a top-emission type organic EL display device in which organic EL light 2117 is taken out through the upper transparent electrode 2106.

The partition insulating film 2105 is made of silicon nitride or an organic polymer material. The lower reflective electrode 2103 is required to have conductivity and light reflection characteristics, and, hence, a material film mainly containing aluminum or chromium is suitable. The upper transparent electrode 2106 is required to have conductivity and visible light transmittance, and, hence, is suitably formed of an oxide material such as an indium tin oxide, an indium zinc oxide, or a zinc oxide. The thickness of the electrode is set arbitrarily based on the correlation between the conductivity and the transparency. The light-emission characteristics of the organic EL layer 2104 are degraded depending upon the temperature, and, hence, the organic EL layer 2104 is suitably formed by sputtering, ion plating, or an electron beam method at a temperature of room temperature or higher and 80°C or lower.

On the upper layer of the upper transparent electrode 2106, a gas barrier film 2107 that does not transmit moisture or oxygen with respect to the organic EL layer 2104 covers the entire display area of the display device. As the bas barrier film 2107, a silicon nitride film or a silicon oxynitride film is suitable. The thickness of the gas barrier film 2107 is set arbitrarily based on the correlation between the gas barrier property and the transparency. The gas barrier film 2107 is required to be formed at relatively low temperature and to have gas barrier properties. Therefore, the gas barrier film 2107 is suitably formed by plasma chemical vapor deposition (CVD) at a temperature of room temperature or higher and 80°C or lower, in particular, by high-density plasma CVD based on an inductive coupling type system.

On the upper surface of the gas barrier film 2107, floating electrodes 2108 that are not connected electrically to anywhere are formed. As the floating electrodes 2108, a transparent conductive material is used. In this embodiment, the floating electrodes 2108 are patterned using an indium tin oxide material with high conductivity above the organic EL layer 2104 so as to correspond to the pattern thereof via a mask. Another oxide conductive material may be used in place of the indium tin oxide material.

Next, a transparent substrate is prepared, and a counter transparent substrate for sealing (hereinafter, referred to as a counter transparent substrate) 2115 with the touch sensor circuit layer 2110 formed thereon is produced by the following production procedure.

As the substrate, there may be used a glass substrate which has good transparency in a visible light region including non-alkali glass, soda glass, alkali glass such as borosilicate glass, and chemically strengthened glass. In addition, polyester films having transparency such as polyethylene terephthalate and polyethylene naphthalate and polyimide films having high heat resistance and high transparency are also known, and such resin-based substrate having transparency may also be used.

In the capacitive coupling touch sensor circuit layer 2110, a circuit is formed in a display screen using a transparent electrode. The transparent electrode is suitably formed of an oxide material such as an indium tin oxide, an indium zinc oxide, or a zinc oxide having a certain high level of conductivity and a function of transmitting visible light. For example, an indium tin oxide film is formed using well-known vacuum sputtering. Then, a photoresist is applied to the indium tin oxide film, followed by exposure and development, using well-known photolithography; whereby a desired pattern is formed. Next, using the photoresist pattern thus obtained as a mask, a transparent electrode is patterned by etching, and the photoresist is removed, whereby a desired transparent electrode pattern is obtained.

The thickness of the electrode is arbitrarily set based on the correlation between the conductivity and the transparency. Further, the shape of the coordinate electrode is arbitrarily set so as to obtain performance in which a position signal is detected satisfactorily from the ratio between a signal of capacitive coupling and a noise as a detection circuit.

The coordinate electrodes 2112 and 2114 correspond to the X-position coordinate and the Y-position coordinate in the touch panel device. Here, those are determined as the touch position coordinate detection transparent electrode (X-coordinate) and the touch position coordinate detection transparent electrode (Y-coordinate), however, it is not necessary that the upper and lower relationship of the coordinate electrodes 2112 and 2114 be XY.

The transparent electrodes to become the coordinate electrodes 2112 and 2114 are obtained by, for example, forming an indium tin oxide film to have the thickness of 5 to 100 nm using well-known vacuum sputtering. Then, a photoresist is applied to the indium tin oxide film, followed by exposure and development, using well-known photolithography, whereby a desired coordinate electrode pattern is formed. Next, using the photoresist pattern thus obtained as a mask, a transparent electrode is patterned by etching, and the photoresist is removed, whereby a desired transparent electrode pattern made of transparent electrodes is obtained.

As the insulating films 2111 and 2113, an insulating film material with light transmittance is suitable. The film thickness can be selected considering the light transmittance and the dielectric constant of the insulating material. In the case where the insulating film has a specific dielectric constant of 3 to 4, the film thickness is suitably 1 to 20 µm.

In the case where the substrate is the above-mentioned glass substrate, the substrate per se does not transmit water or oxygen, and, hence, the insulating films 2111 and 2113 are not required to have a barrier property with respect to water and oxygen. Therefore, as the material for the insulating films, a photosensitive material can be used. The use of the photosensitive material is suitable for forming an opening pattern when forming the above-mentioned capacitive coupling touch sensor circuit layer 2110. As a combination of an acrylic resin, an acrylic epoxy-based resin, or a siloxane-based resin as a base polymer with a photosensitive agent, a positive photosensitive material that allows a portion irradiated with light to be developed, dissolved, and removed, and a negative photosensitive material that allows a portion not irradiated with light to be developed, dissolved, and removed are known. Those materials can be used. As a developing solution, an alkali aqueous solution or an organic solvent can be used depending upon each photosensitive material.

It is necessary for the insulating film to have light transmittance of 80% or more in order not to decrease the performance of an image display device. If components such as a base polymer and a photosensitive agent having small light absorption in a visible light region (400 nm to 800 nm) are selected in the negative photosensitive material, the insulating film material can realize light transmittance. Further, in the positive photosensitive material, a base polymer having small light absorption in a visible light region is selected, and a photosensitive agent is subjected to photo-bleaching, whereby the light transmittance in a visible light region can be enhanced.

Further, in the case where the substrate is the above-mentioned resin-based substrate having transparency, the substrate per se is likely to transmit water and oxygen. Therefore, the insulating films 2111 and 2113 are required to have a barrier property with respect to water and oxygen. Therefore, as the material for the insulating films, a silicon nitride film or a silicon oxynitride film is suitable. The thickness of the insulating film is set arbitrarily based on the correlation between the gas barrier property and the transparency.

An adhesive is applied over the entire periphery of the outside frame of the display area on the substrate 2101 in which the organic EL layer 2104 produced as described above is formed, and the counter transparent substrate 2115 for sealing is attached to the substrate 2101 to seal the display area (not shown). As the adhesive used for sealing, a light-curable material capable of being treated at a low temperature is suitably used.

In a space layer 2109 sealed with the substrate 101 and the counter transparent substrate 2115 for sealing, inactive gas such as nitrogen, argon, or helium with a low humidity and a low oxygen concentration is sealed. The thickness of the space layer 2109 is suitably 5 µm or more and 120 µm or less.

Finally, the display device is completed by being connected to a peripheral circuit on which a driver LSI for driving a thin film transistor or an LSI for control and a power source is mounted.

In the display device containing a capacitive coupling type touch sensor function thus obtained, the XY-position coordinate electrodes 2112 and 2114 and the floating electrodes 2108 are allowed to approach each other due to the load occurring when the substrate having a touch sensor electrode circuit is touched with the resin pen 2116, whereby capacitive coupling occurs between the floating electrodes and the XY-position coordinate electrodes. By detecting a position where the capacitive coupling occurs, the position touched with a resin pen is detected, and positional information can be input to the display device.

### [Embodiment 15]

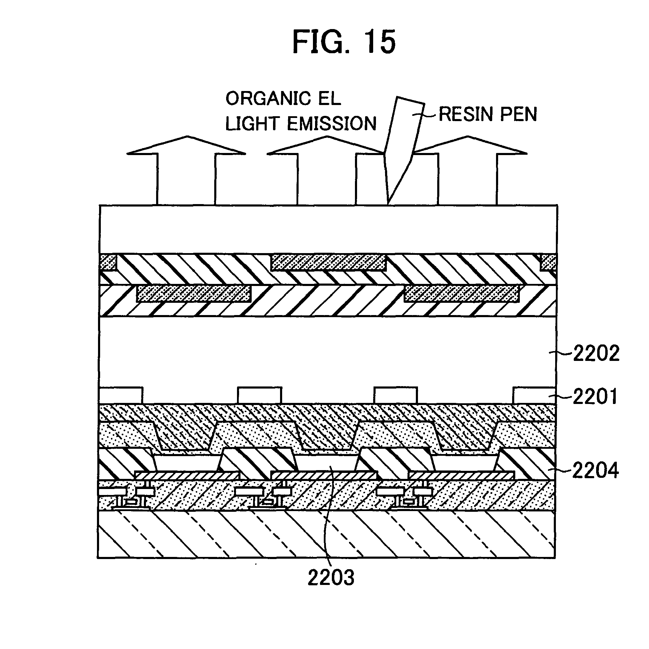

A display device containing a capacitive coupling type touch sensor of Embodiment 15 illustrated in FIG. 15 is produced under the following conditions. In FIG. 15, reference numeral 2201 denotes floating electrodes, reference numeral 2202 denotes a space layer (inactive gas layer), reference numeral 2203 denotes an organic EL layer, and reference numeral 2204 denotes a partition insulating film. The other components are the same as those in Embodiment 14.

In this embodiment, unlike Embodiment 14, the floating electrodes 2201 are patterned above the partition insulating film 2204 so as to correspond thereto, instead of being patterned above the organic EL layer 2203 so as to correspond thereto. For the floating electrodes 2201, a transparent conductive material or an opaque conductive material may be used.

In the display device containing a capacitive coupling type touch sensor function obtained accordingly, the XY-position coordinate electrodes and the floating electrodes are also allowed to approach each other due to the load occurring when the substrate having a touch sensor electrode circuit is touched with the resin pen 2116, whereby capacitive coupling occurs between the floating electrodes and the XY-position coordinate electrodes. By detecting a position where the capacitive coupling occurs, the position touched with the resin pen 2116 is detected, and positional information can be input to the display device.

### [Embodiment 16]

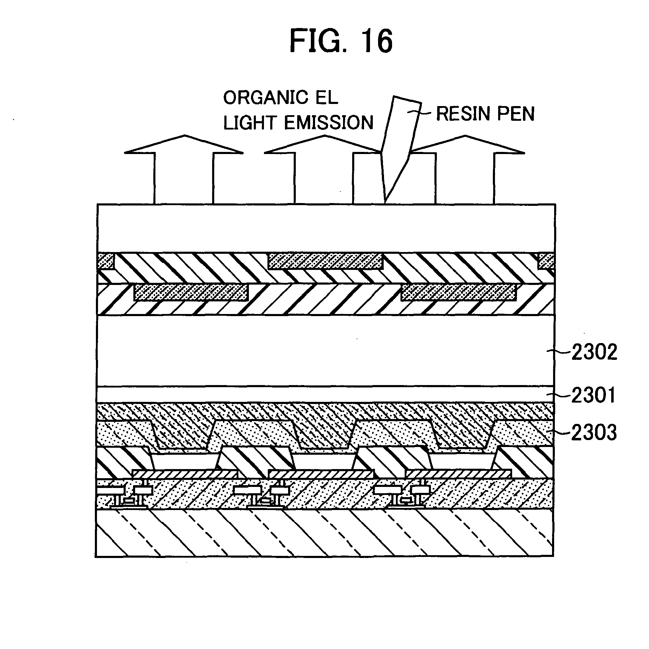

A display device containing a capacitive coupling type touch sensor of Embodiment 16 illustrated in FIG. 16 is produced under the following conditions. In FIG. 16, reference numeral 2301 denotes a floating electrode, reference numeral 2302 denotes a space layer (inactive gas layer), and reference numeral 2303 denotes a gas barrier film. The other components are the same as those in Embodiments 15 and 16.

In this embodiment, unlike Embodiments 15 and 16, the floating electrode 2301 is formed over the entire upper surface of the gas barrier film 2303, using a conductive material with low conductivity. As a conductive material with low conductivity in this embodiment, a conductive material with a specific resistance of 40 mΩ·cm or more is desired. Further, a transparent conductive material is used for the floating electrode 2301.

Conductive materials including organic compounds may also be used as a material having low conductivity. As the organic conductive material, there may be used polyacetylene, polyazulene, polyphenylene, polyphenylenevinylene, polyacene, polyphenylacetylene, polydiacetylene, polyaniline, polyethylenedioxythiophene, polythiophene, polyisothianaphthene, polypyrrole, or the like.

In the display device containing a capacitive coupling type touch sensor function thus obtained, the XY-position coordinate electrodes and the floating electrodes are also allowed to approach each other due to the load occurring when the substrate having a touch sensor electrode circuit is touched with the resin pen 2116, whereby capacitive coupling occurs between the floating electrodes and the XY-position coordinate electrodes. By detecting a position where the capacitive coupling occurs, the position touched with the resin pen 2116 is detected, and positional information can be input to the display device.

### [Embodiment 17]

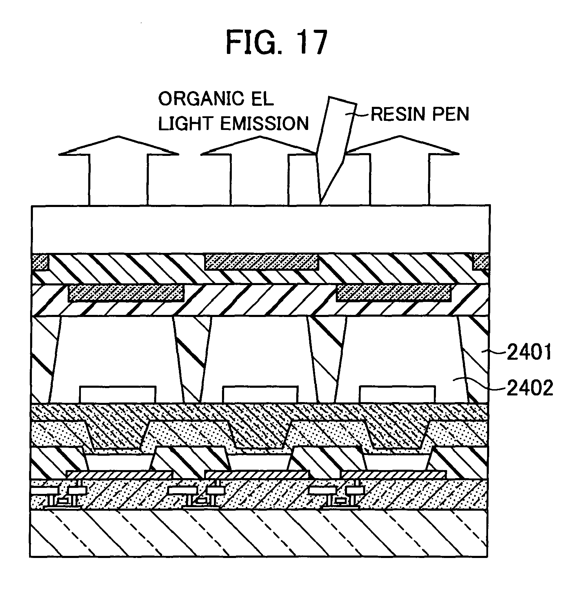

A display device containing a capacitive coupling type touch sensor of Embodiment 17 illustrated in FIG. 17 is produced under the following conditions. In FIG. 17, reference numeral 2401 denotes a spacer, and reference numeral 2402 denotes a space layer (inactive gas layer). The other components are the same as those in Embodiment 1.

In this embodiment, unlike Embodiment 14, spacers 2401 are formed for the purpose of precisely controlling the thickness of the space layer 2402 sealed by the substrate having floating electrodes and the sealing substrate.

As a material for the spacers 2401, a photosensitive material is used because it is suitable for forming a pattern. As a combination of an acrylic resin, an acrylic epoxy-based resin, or a siloxane-based resin as a base polymer with a photosensitive agent, a positive photosensitive material that allows a portion irradiated with light to be developed, dissolved, and removed, and a negative photosensitive material that allows a portion not irradiated with light to be developed, dissolved, and removed are known. Those materials can be used. As a developing solution, an alkali aqueous solution or an organic solvent can be used depending upon each photosensitive material.

Here, the step of using an acrylic negative photosensitive material capable of being developed with an alkali aqueous solution is described. A material solution is applied to the upper layer of a touch sensor circuit layer. Then, the material solution is heated at 90°C for 5 minutes with a hot plate to obtain a prebaked film. Next, the prebaked film is irradiated with light via a photomask for forming a desired pattern to be cured optically. Then, the prebaked film is developed using an alkali aqueous solution containing tetramethyl ammonium hydroxide by 2.38 wt%, and a portion not irradiated with light is dissolved to be removed, whereby a desired pattern is formed. Then, the film is heated to be cured at 230°C for 10 minutes with a hot plate to obtain the spacers 2401. The height of the spacers is set to be 5 µm or more and 120 µm or less.

In the display device containing a capacitive coupling type touch sensor function thus obtained, the XY-position coordinate electrodes and the floating electrodes are also allowed to approach each other due to the load occurring when the substrate having a touch sensor electrode circuit is touched with the resin pen 2116, whereby capacitive coupling occurs between the floating electrodes and the XY-position coordinate electrodes. By detecting a position where the capacitive coupling occurs, the position touched with the resin pen 2116 is detected, and positional information can be input to the display device.

### [Embodiment 18]

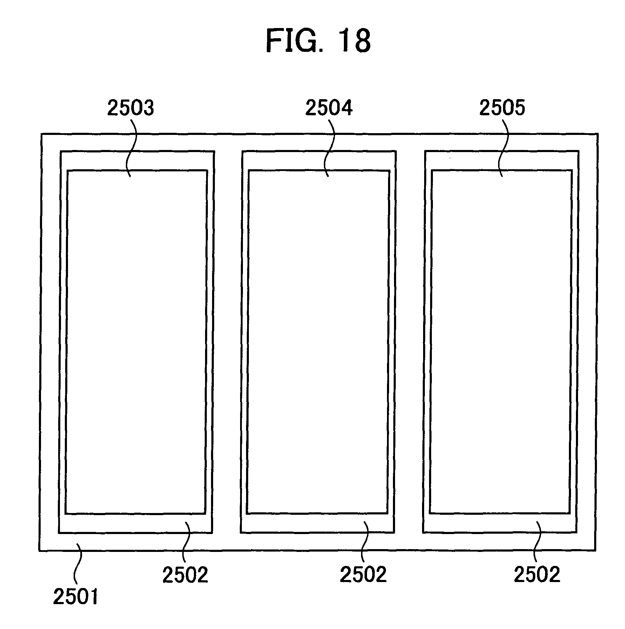

In the embodiment illustrated in FIG. 18, the relative position of the pattern of the floating electrodes and the pattern of the organic EL layers described in Embodiment 14 is illustrated. In FIG. 18, reference numeral 2501 denotes a partition insulating film, reference numeral 2502 denotes a floating electrode pattern, reference numeral 2503 denotes a light-emitting layer pattern (R), reference numeral 2504 denotes a light-emitting layer pattern (G), and reference numeral 2505 denotes a light-emitting layer pattern (B). In a display device performing a full-color display, three-color light-emitting layer patterns of R (red), G (green), and B (blue) are required, and floating electrodes are formed using a mask film correspondingly to the respective light-emitting layer patterns.

### [Embodiment 19]

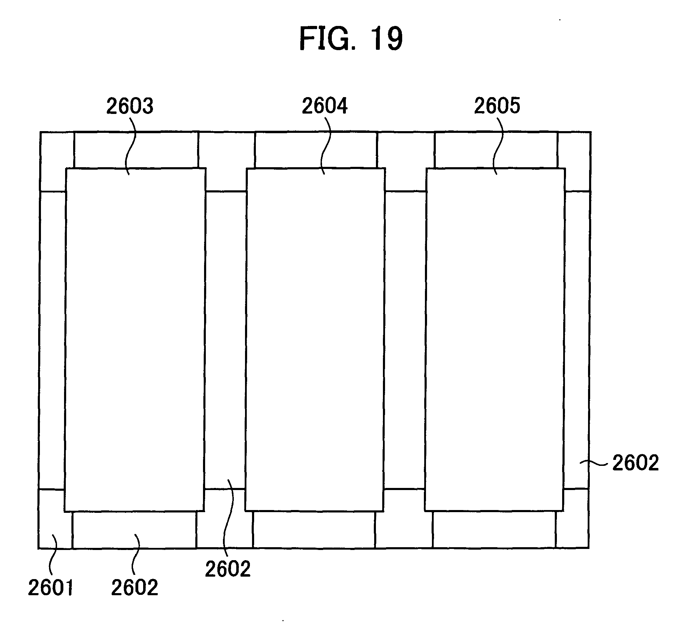

In the embodiment illustrated in FIG. 19, the relative position of the pattern of the floating electrodes and the pattern of the organic EL layers described in Embodiment 15 is illustrated. In FIG. 19, reference numeral 2601 denotes a partition insulating film, reference numeral 2602 denotes a floating electrode pattern, reference numeral 2603 denotes a light-emitting layer pattern (R), reference numeral 2604 denotes a light-emitting layer pattern (G), and reference numeral 2605 denotes a light-emitting layer pattern (B). The floating electrodes are formed at positions corresponding to the partition insulating film, using a mask film.

### [Embodiment 20]

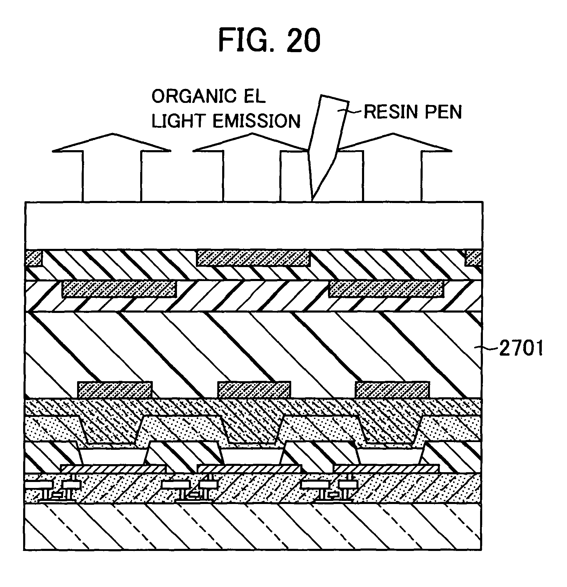

In the embodiment illustrated in FIG. 20, unlike Embodiments 14, 15, and 16, the inside of the sealing is formed as a resin layer 2701 at a time of the above-mentioned attachment of the substrates. In this embodiment, an addition polymerization type silicone resin is used as a material for the resin and, and is formed to have the thickness of 50 µm. At this time, the resin layer is deformed by 50% of a thickness thereof with a load of 82 g of a pen touch. Further, in this embodiment, the refractive index is 1.4, and the light transmittance is 98% ormore at a wavelength of 400 to 800 nm. However, the refractive index may be 1.30 or more and 1.52 or less, and the light transmittance may be 80% or more. In addition, the characteristics obtained by forming the resin layer arbitrarily to have a thickness range of 5 µm or more and 120 µm or less have the same results.

In the display device containing a capacitive coupling type touch sensor function thus obtained, similarly, due to the load occurring when the substrate having a touch sensor electrode circuit is touched with the resin pen 2116, the resin layer is deformed by the load in the thickness direction, and the XY-position coordinate electrodes and the floating electrodes are allowed to approach each other, whereby capacitive coupling occurs between the floating electrodes and the XY-position coordinate electrodes. By detecting a position where the capacitive coupling occurs, the position touched with the resin pen 2116 is detected, and positional information can be input to the display device.

Any display devices containing a capacitive coupling type touch sensor in each embodiment described above are organic electroluminescence display devices. However, the display devices of the present invention are not limited thereto and may be any self-emitting display devices. Further, the display device may be a non-self-emitting display device (for example, liquid crystal display device). That is, the display device combined with a capacitive coupling type touch sensor of the embodiments of the present invention may include a display device and a transparent substrate provided at a position isolated from and opposed to the display device. The display device may include a capacitive coupling type touch sensor electrode circuit including an XY-position coordinate electrode that detects an XY-position coordinate on a transparent substrate opposed to the display device, floating electrodes that is placed at positions isolated from and opposed to the touch sensor electrode circuit on the display device. The XY-position coordinate electrodes and the floating electrodes may approach each other when the transparent substrate having the touch sensor electrode circuit is touched with a pen so that capacitive coupling may occur between the XY-position coordinate electrodes and the floating electrodes. By doing so, the position touched with a pen is detected.

While there have been described what are at present considered to be certain embodiments of the invention, it will be understood that various modifications may be made thereto, and it is intended that the appended claim covers all such modifications as fall within the true spirit and scope of the invention as defined by this claim.

## Claims

1. A capacitive coupling type touch panel comprising:
an XY-coordinate electrode configured to detect an XY-position coordinate, wherein the XY-coordinate electrode is provided on a transparent substrate and detects a position inputted by capacitive coupling; and
an electrode provided at a position so as to be isolated from and opposed to the XY-coordinate electrode.

2. The capacitive coupling type touch panel according to claim 1, wherein the electrode comprises at least a floating electrode that is provided so as to be insulated.

3. The capacitive coupling type touch panel according to claim 2 further comprising a first transparent substrate having the XY-coordinate,
wherein at least the floating electrode comprises a plurality of floating electrodes that are provided in a line in a direction along a surface of the first transparent substrate.

4. The capacitive coupling type touch panel according to claim 2 or 3, further comprising a second transparent substrate opposed to the first transparent substrate,
wherein the floating electrode comprises a transparent electrode, and
wherein the floating electrode is provided on the second transparent substrate.

5. A capacitive coupling type touch panel according to any one of claims 2 to 4, wherein the XY-coordinate electrode and the floating electrode are provided so that a distance therebetween is variable.

6. The capacitive coupling type touch panel according to claim 5 further comprising an insulating film between the XY-coordinate electrode and the floating electrode,
wherein the insulating film is deformed elastically so as to vary the distance.

7. The capacitive coupling type touch panel according to claim 6, wherein a light transmittance of the insulating film is 80% or more in a visible light region.

8. The capacitive coupling type touch panel according to claim 4 further comprising a liquid layer between the XY-coordinate electrode and the floating electrode.

9. The capacitive coupling type touch panel according to claim 4 further comprising a gas layer that is sealed between the XY-coordinate electrode and the floating electrode.

10. The capacitive coupling type touch panel according to claim 3 further comprising:
a third substrate that is opposed to the first transparent substrate; and
a light emitting layer having an organic electroluminescence layer that emits light in a direction of the first transparent substrate and is provided on the third substrate,
wherein the floating electrode is provided on the organic electroluminescence layer.

11. The capacitive coupling type touch panel according to claim 10 further comprising a gas layer that is sealed between the first transparent substrate and the third substrate,
wherein the gas layer is interposed between the XY-coordinate electrode and the floating electrode.

12. The capacitive coupling type touch panel according to claim 1, wherein the capacitive coupling type touch panel receives an input based on a variation of capacitive coupling that occurs between the XY-coordinate electrode and the electrode.

13. The capacitive coupling type touch panel according to claim 3,
wherein when one of the first transparent substrate and the second transparent substrate is touched with an insulator, a distance between the XY-coordinate electrode and the floating electrode is varied so that the capacitive coupling that occurs between the XY-coordinate electrode and the floating electrode varies, and
wherein the capacitive coupling type touch panel detects a position where the insulator is touched by detecting a variation of the capacitive coupling.
